# EUROPÄISCHE PATENTSCHRIFT

(11) **EP 2 528 991 B1**
(45) Veröffentlichungstag und Bekanntmachung des Hinweises auf die Patenterteilung: **26.11.2014**
(21) Anmeldenummer: 10798019.5
(22) Anmeldetag: 28.12.2010
(51) Int. Cl.: C09K 11/59

(54) **LEUCHTSTOFFE**
LUMINESCENT SUBSTANCES
SUBSTANCES LUMINESCENTES

(30) Priorität: 29.01.2010 EP 10000933
(43) Veröffentlichungstag der Anmeldung: 05.12.2012
(73) Patentinhaber: Merck Patent GmbH, 64293 Darmstadt (DE)
(72) Erfinder: WINKLER, Holger, 64291 Darmstadt (DE); BARNEKOW, Peter, 68766 Hockenheim (DE); KUEHN, Clemens, 64291 Darmstadt (DE); PETRY, Ralf, 64347 Griesheim (DE); VOSGROENE, Tim, 64372 Ober-Ramstadt (DE); JUESTEL, Thomas, 58455 Witten (DE); UHLICH, Dominik, 48565 Steinfurt (DE); KATELNIKOVAS, Arturas, 48565 Steinfurt (DE); DUTCZAK, Danuta, 48565 Steinfurt (DE)
(86) Internationale Anmeldenummer: PCT/EP2010/007954
(87) Internationale Veröffentlichungsnummer: WO 2011/091839

(56) Entgegenhaltungen:
- EP-A2- 1 669 429
- WO-A1-2007/096333
- WO-A1-2008/096301
- DE-T5-112006 000 291
- JP-A- 2003 321 675
- US-A1- 2006 244 358

## Beschreibung

Die Erfindung betrifft neue Verbindungen, Mischungen enthaltend diese, Verfahren zur Herstellung dieser Leuchtstoffe und Mischungen und deren Verwendung als Konversionsleuchtstoffe bzw. in Leuchtmitteln.

LEDs gewinnen zunehmend an Bedeutung - sowohl als Beleuchtungsmittel als auch bei der Verwendung als Hintergrundbeleuchtung in Flüssigkristall-Displays (FK-Displays). Diese neuartigen Lichtquellen weisen gegenüber den herkömmlichen Kaltkathodenfluoreszenzlampen (cold cathode fluorescence lamps - CCFL) mehrere Vorteile auf, wie längere Lebensdauer, potentielle Energieersparnis, Abwesenheit schädlicher Inhaltsstoffe (wie Quecksilber in CCFL).

In der Vergangenheit wurden beispielsweise Anordnungen aus LEDs, die blaues, grünes und rotes Licht emittieren, als Hintergrundbeleuchtungsquelle für FK-TV-Anwendungen eingesetzt. Dieser Multi-Chip-Ansatz hat jedoch einige Nachteile: es ist ausgesprochen schwierig, drei verschiedene Chipmaterialien zu kombinieren und Einheitlichkeit und Stabilität der Lichtparameter wie Farbpunkt sicherzustellen.

Es wurden daher pcLEDs ("phosphor converted LEDs") als Lichtquellen für die Verwendung als Hintergrundbeleuchtung eingeführt. Diese enthalten üblicherweise einen grünen Leuchtstoff und einen tiefroten Leuchtstoff zusammen mit der blauen Lichtemission eines LED-Chips, die entsprechend den Transmissionsspektren des Farbfilters (Transmissionsbanden im blauen, grünen und roten Bereich des Spektrums) angeglichen sind. Theoretisch ermöglicht ein derartiger Aufbau Farbräume, die viel größer als der übliche sRGB sind. Aufgrund von Engpässen in der Verfügbarkeit geeigneter Qualitäten, besteht noch immer Bedarf an weiteren optimierten Leuchtstoffen und/oder Leuchtstoff-Gemischen.

Insbesondere besteht dabei Bedarf nach roten Leuchtstoffen. Zur Erzielung hoher Farbräume mittels LED TV-Backlighting sind tiefrote Leuchtstoffe erforderlich, welche ein Emissionsmaximum aufweisen in Bereich von 620 nm -660 nm. Dem Fachmann bekannte und geeignete Materialsystem stellen Siliconitride und Alumosilikonitride dar (vgl. Xie, Sci. Technol. Adv. Mater. 2007, 8, 588-600): 1-1-2-Nitride, wie z.B. das CaSiN₂:Eu²⁺ (Le Toquin, Cheetham, Chem. Phys. Lett. 2006, 423, 352.), 2-5-8-Nitride, wie das (Ca,Sr,Ba)₂Si₅N₈:Eu²⁺ (Li et al., Chem. Mater. 2005, 15, 4492) und Alumosilikonitride, wie das (Ca,Sr)AlSiN₃:Eu²⁺ (K. Uheda et al., Electrochem. Solid State Lett. 2006, 9, H22).

Das Dokument DE 11 2006 000291 T5 beschreibt einen Leuchtstoff, der die folgenden drei Phasen enthält: Sr1.8Si500.4N7.6, α-Typ Sr2Si04 und β-Typ Sr2Si04. Europium wird als Dotierstoff verwendet.

Nitridische Leuchtstoffe, wie oben genannt, sind präparativ oft aufwändig und daher nicht oder nur zu sehr hohen Kosten in großen Mengen verfügbar. Insbesondere die hohe erforderliche Reinheit stellt eine technisch nur unter hohem Aufwand realisierbare Herausforderung dar. So können geringste Konzentrationen von Kohlenstoff oder Sauerstoff dazu führen, dass die Effizienz der Leuchtstoffe empfindlich verringert wird. Weiter ist es wünschenswert Materialien zu Verfügung zu haben, die gegen Feuchtigkeit möglichst wenig empfindlich sind.

Eine Aufgabe der vorliegenden Erfindung ist es daher im roten Spektralbereich emittierende Materialen zu Verfügung zu stellen, die unter Produktionsbedingungen mit wirtschaftlich vertretbarem Aufwand erhalten werden können bzw. im Vergleich zu bekannten nitridischen Leuchtstoffen eine geringere Feuchtigkeitsempfindlichkeit aufweisen.

Dabei wird im Kontext dieser Anmeldung als rote Emission oder rotes Licht solches Licht bezeichnet dessen Intensitätsmaximum zwischen 610 nm und 670 nm Wellenlänge liegt, entsprechend wird als grün solches Licht bezeichnet, dessen Maximum zwischen 508 nm und 550 nm Wellenlänge liegt und als gelb Licht, dessen Maximum zwischen 551 nm und 585 nm Wellenlänge liegt.

Überraschenderweise wurde nun gefunden, dass bestimmte Oxynitride den 2-5-8-Nitriden vergleichbare Leuchtstoffeigenschaften aufweisen, jedoch hinsichtlich Sauerstoffgehalt und Phasenreinreinheit wesentlich geringere Anforderungen an die Herstellverfahren stellen bzw. eine geringere Empfindlichkeit gegenüber Feuchtigkeit aufweisen..

Eine erste Ausführungsform der vorliegenden Erfindung ist daher eine Verbindung der Formel I,

A_{2-0,5y-x} Euₓ Si₅ N_{8-y} O_{y} (I)

wobei A steht für ein oder mehrere Elemente ausgewählt aus Ca, Sr, Ba und x steht für einen Wert aus dem Bereich von 0,005 bis 1 und y steht für einen Wert aus dem Bereich von 0,01 bis 3.

Dabei kann die Verbindung der Formel I als Reinstoff oder im Gemisch vorliegen. Ein weiterer Gegenstand der vorliegenden Erfindung ist daher eine Mischung enthaltend mindestens eine Verbindung der Formel I, wie oben definiert, und mindestens eine weitere Silicium und Sauerstoff enthaltende Verbindung.

Erfindungsgemäß bevorzugt ist es dabei, wenn die mindestens eine weitere Silicium und Sauerstoff enthaltende Verbindung ein Reaktionsnebenprodukt der Herstellung der Verbindung der Formel I ist und diese die anwendungsreleventen optischen Eigenschaften der Verbindung der Formel I nicht nachtelig beeinflusst.

Daher ist eine Mischung enthaltend eine Verbindung der Formel I, die erhältlich ist, durch ein Verfahren, bei dem in einem Schritt a) geeignete Edukte ausgewählt aus binären Nitriden, Halogeniden und Oxiden oder entsprechenden reaktiven Formen dazu gemischt werden und das Gemisch in einem Schritt b) unter reduktiven Bedingungen thermisch behandelt wird ein weiterer Erfindungsgegenstand.

Das entsprechende Verfahren zur Herstellung der Verbindungen der Formel I bzw. der Mischungen sowie die erfindungsgemäße Verwendung der Verbindungen der Formel I bzw. der o.g. Mischungen als Konversions-leuchtstoff, insbesondere zur teilweisen oder vollständigen Konversion der blauen oder im nahen UV-liegenden Emission einer Lumineszenzdiode sind weitere Erfindungsgegenstände.

Im Folgenden werden die erfindungsgemäßen Verbindungen der Formel I bzw. die Mischungen o.g. erfindungsgemäßen Mischungen gemeinsam auch vereinfacht als Leuchtstoffe bezeichnet.

In solchen Mischungen ist die Verbindung der Formel I üblicherweise zu einen Gewichtsanteil aus dem Bereich von 30 - 95 Gew.-%, vorzugsweise aus dem Bereich von 50 - 90 Gew.-% und insbesondere bevorzugt aus dem Bereich von 60 - 88 Gew.-% enthalten.

Bei der mindestens einen Silicium und Sauerstoff enthaltenden Verbindung handelt es sich in bevorzugten Ausführungsformen der Erfindung um röntgenamorphe oder glasartige Phasen, die sich durch einen hohen Silicium und Sauerstoffgehalt auszeichnen, aber auch Metalle, insbesondere Erdalkalimetalle wie Strontium enthalten können. Dabei kann es wiederum bevorzugt sein, wenn diese Phasen die Partikel der Verbindung der Formel I ganz oder teilweise umhüllen.

In den erfindungsgemäßen Verbindungen der Formel I steht A in bevorzugten Ausführungsformen für Sr, während x in bevorzugten Ausführungsformen steht für einen Wert aus dem Bereich von 0,01 bis 0,8, vorzugsweise aus dem Bereich 0,02 bis 0,7 und insbesondere bevorzugt aus dem Bereich 0,05 bis 0,6 und insbesondere bevorzugt aus dem Bereich 0,1 bis 0,4 und y in bevorzugten Ausführungsformen steht für einen Wert aus dem Bereich von 0,1 bis 2,5, vorzugsweise aus dem Bereich 0,2 bis 2 und insbesondere bevorzugt aus dem Bereich 0,22 bis 1,8.

Erfindungsgemäße Mischungen bzw. Verbindungen in geringen Mengen eingesetzt ergeben bereits gute LED-Qualitäten. Die LED-Qualität wird dabei über übliche Parameter, wie beispielsweise den Color Rendering Index, die Correlated Color Temperature, Lumenäquivalente oder absolute Lumen, bzw. den Farbpunkt in CIE x und CIE y Koordinaten beschrieben.

Der Color Rendering Index oder CRI ist eine dem Fachmann geläufige, einheitslose lichttechnische Größe, welche die Farbwiedergabetreue einer künstlichen Lichtquelle mit derjenigen des Sonnenlichtes bzw. und Filamentlichtquellen vergleicht (die beiden letztgenannten besitzen einen CRI von 100).

Die CCT oder Correlated Color Temperature ist eine dem Fachmann geläufige, lichttechnische Größe mit der Einheit Kelvin. Je höher der Zahlenwert, desto kälter erscheint dem Betrachter das Weißlicht einer künstlichen Strahlungsquelle. Die CCT folgt dem Konzept des Schwarzlichtstrahlers, dessen Farbtemperatur der sog. Planckschen Kurve im CIE Diagramm verläuft.

Das Lumenäquivalent ist eine dem Fachmann geläufige lichttechnische Größe mit der Einheit Im/W, die beschreibt, wie groß der photometrische Lichtstrom in Lumen einer Lichtquelle bei einer bestimmten radiometrischen Strahlungsleistung mit der Einheit Watt, ist. Je höher das Lumenäquivalent ist, desto effizienter ist eine Lichtquelle.

Das Lumen ist eine dem Fachmann geläufige, photometrische lichttechnische Größe, welche den Lichtstrom einer Lichtquelle, der ein Maß für die gesamte von einer Strahlungsquelle ausgesandte sichtbare Strahlung ist, beschreibt. Je größer der Lichtstrom, desto heller erscheint die Lichtquelle dem Beobachter.

CIE x und CIE y stehen für die Koordinaten im dem Fachmann geläufigen CIE Normfarbdiagramm (hier Normalbeobachter 1931), mit denen die Farbe einer Lichtquelle beschrieben wird.

Alle oben aufgeführten Größen werden nach dem Fachmann geläufigen Methoden aus Emissionsspektren der Lichtquelle berechnet.

Die Anregbarkeit der erfindungsgemäßen Leuchtstoffe erstreckt sich zudem über einen weiten Bereich, der von etwa 410 nm bis 530 nm, bevorzugt 430 nm bis zu etwa 500 nm reicht. Damit sind diese Leuchtstoffe nicht nur zur Anregung durch UV oder blau emittierende Primärlichtquellen wie LEDs oder konventionelle Entladungslampen (z.B. auf Hg-Basis) geeignet, sondern auch für Lichtquellen wie solche, welche die blaue In³⁺ -Linie bei 451 nm ausnutzen.

Vorteilhaft ist bei den erfindungsgemäßen Leuchtstoffen weiterhin die Stabilität gegenüber Feuchtigkeit und Wasserdampf, der über Diffusionsprozesse aus der Umgebung in das LED package und damit an die Oberfläche des Leuchtstoffes gelangen kann sowie die Stabilität gegenüber sauren Medien, die als Nebenprodukte beim Aushärten des Bindemittels im LED package oder als Additive im LED package auftreten können. Erfindungsgemäß bevorzugte Leuchtstoffe weisen dabei Stabilitäten auf, die höher sind als die bislang üblicher nitridscher Leuchtstoffe.

Bei dem erfindungsgemäßen Verfahren zur Herstellung erfindungsgemäßer Leuchtstoffe werden in einem Schritt a) geeignete Edukte ausgewählt aus binären Nitriden, Halogeniden und Oxiden oder entsprechenden reaktiven Formen dazu gemischt und das Gemisch in einem Schritt b) unter reduktiven Bedingungen thermisch behandelt wird.

Bei der oben genannten thermischen Behandlung ist es bevorzugt, wenn diese zumindest teilweise unter reduzierenden Bedingungen durchgeführt wird.

Im Schritt b) erfolgt die Umsetzung üblicherweise bei einer Temperatur oberhalb 800 C, vorzugsweise bei einer Temperatur oberhalb 1200°C und insbesondere bevorzugt im Bereich von 1400°C - 1800°C.

Die reduktiven Bedingungen werden dabei z.B. mit Kohlenmonoxid, Formiergas oder Wasserstoff oder zumindest Vakuum oder Sauerstoffmangel-Atmosphäre eingestellt, bevorzugt im Stickstoffstrom, vorzugsweise im N2/H2-Strom und insbesondere bevorzugt im N2/H2/NH3-Strom eingestellt.

Soll die Verbindungen der Formel I rein hergestellt werden, so kann dies entweder über genaue Kontrolle der Eduktstöchiometrie oder durch mechanisches Abtrennen der Kristalle der Verbindungen der Formel I von den glasartigen Anteilen erfolgen. Die Abtrennung kann beispielsweise über die unterschiedliche Dichte, Partikelform oder Partikelgröße nach dem Fachmann bekannten Trennmethoden erfolgen.

Ein weiterer Gegenstand der vorliegenden Erfindung ist eine Lichtquelle mit mindestens einer Primärlichtquelle, die mindestens einen erfindungsgemäßen Leuchtstoff enthält. Dabei liegt das Emissionsmaximum der Primärlichtquelle üblicherweise im Bereich 410 nm bis 530 nm, bevorzugt 430 nm bis zu etwa 500 nm. Insbesondere bevorzugt ist ein Bereich zwischen 440 und 480 nm, wobei die primäre Strahlung teilweise oder vollständig durch die erfindungsgemäßen Leuchtstoffe in längerwellige Strahlung konvertiert wird.

In einer bevorzugten Ausführungsform der erfindungsgemäßen Lichtquelle handelt es sich bei der Primärlichtquelle um ein lumineszentes IndiumAluminiumGalliumNitrid, insbesondere der Formel

InᵢGaⱼAlₖN,

wobei 0 ≤ i, 0 ≤ j, 0 ≤ k, und i+j+k=1 ist.

Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Lichtquelle handelt es sich bei der Primärlichtquelle um eine lumineszente auf ZnO, TCO (Transparent conducting oxide), ZnSe oder SiC basierende Anordnung oder auch um eine auf einer organischen lichtemittierende Schicht basierende Anordnung (OLED).

In einer weiteren bevorzugten Ausführungsform der erfindungsgemäßen Lichtquelle handelt es sich bei der Primärlichtquelle um eine Quelle, die Elektrolumineszenz und/oder Photolumineszenz zeigt. Weiterhin kann es sich bei der Primärlichtquelle auch um eine Plasma- oder Entladungsquelle handeln.

Entsprechende erfindungsgemäße Lichtquellen werden auch als Leuchtdioden oder LEDs bezeichnet.

Die erfindungsgemäßen Leuchtstoffe können einzeln, oder als Mischung mit den dem Fachmann geläufigen folgenden Leuchtstoffen eingesetzt werden. Entsprechende Leuchtstoffe sind beispielsweise:
Ba₂SiO₄:Eu²⁺, BaSi₂O₅:Pb²⁺, BaₓSr₁₋ₓF₂:Eu²⁺, BaSrMgSi₂O₇:Eu²⁺, BaTiP₂O₇, (Ba,Ti)₂P₂O₇:Ti, Ba₃WO₆:U, BaY₂F₈:Er³⁺,Yb⁺, Be₂SiO₄:Mn²⁺, Bi₄Ge₃O₁₂, CaAl₂O₄:Ce³⁺, CaLa₄O₇:Ce³⁺, CaAl₂O₄:Eu²⁺, CaAl₂O₄:Mn²⁺, CaAl₄O₇:Pb²⁺,Mn²⁺, CaAl₂O₄:Tb³⁺, Ca₃Al₂Si₃O₁₂:Ce³⁺, Ca₃Al₂Si₃Oi₂:Ce³⁺, Ca₃Al₂Si₃O,₂:Eu²⁺, Ca₂B₅O₉Br:Eu²⁺, Ca₂B₅O₉Cl:Eu²⁺, Ca₂B₅O₉Cl:Pb²⁺, CaB₂O₄:Mn²⁺, Ca₂B₂O₅:Mn²⁺, CaB₂O₄:Pb²⁺, CaB₂P₂O₉:Eu²⁺, Ca₅B₂SiO₁₀:Eu³⁺, Ca_{0.5}Ba_{0.5}Al₁₂O₁₉:Ce³⁺,Mn²⁺, Ca₂Ba₃(PO₄)₃Cl:Eu²⁺, CaBr₂:Eu²⁺ in SiO₂, CaCl₂:Eu²⁺ in SiO₂, CaCl₂:Eu²⁺,Mn²⁺ in SiO₂, CaF₂:Ce³⁺, CaF₂:Ce³⁺,Mn²⁺, CaF₂:Ce³⁺,Tb³⁺, CaF₂:Eu²⁺, CaF₂:Mn²⁺, CaF₂:U, CaGa₂O₄:Mn²⁺, CaGa₄O₇:Mn²⁺, CaGa₂S₄:Ce³⁺, CaGa₂S₄:Eu²⁺, CaGa₂S₄:Mn²⁺, CaGa₂S₄:Pb²⁺, CaGeo₃:Mn²⁺, Cal₂:Eu²⁺ in SiO₂, Cal₂:Eu²⁺,Mn²⁺ in SiO₂, CaLaBO₄:Eu³⁺, CaLaB₃O₇:Ce³⁺,Mn²⁺, Ca₂La₂BO₆.₅:Pb²⁺, Ca₂MgSi₂O₇, Ca₂M_{g}Si₂O₇:Ce³⁺, CaMgSi₂O₆:Eu²⁺, Ca₃MgSi₂O₈:Eu²⁺, Ca₂M₉Si₂O₇:Eu²⁺, CaMgSi₂O₆:Eu²⁺,Mn²⁺, Ca₂MgSi₂O₇:Eu²⁺,Mn²⁺, CaMoO₄, CaMoO₄:Eu³⁺, CaO:Bi³⁺, CaO:Cd²⁺, CaO:Cu⁺, CaO:Eu³⁺, CaO:Eu³⁺, Na⁺, CaO:Mn²⁺, CaO:Pb²⁺, CaO:Sb³⁺, CaO:Sm³⁺, CaO:Tb³⁺, CaO:TI, CaO:Zn²⁺, Ca₂P₂O₇:Ce³⁺, α-Ca₃(PO₄)₂:Ce³⁺, β-Ca₃(PO₄)₂:Ce³⁺, Ca₅(PO₄)₃Cl:Eu²⁺, Ca₅(PO₄)₃Cl:Mn²⁺, Ca₅(PO₄)₃Cl:Sb³⁺, Ca₅(PO₄)₃Cl:Sn²⁺, β-Ca₃(PO₄)₂:Eu²⁺,Mn²⁺, Ca₅(PO₄)₃F:Mn²⁺, Caₛ(PO₄)₃F:Sb³⁺, Caₛ(PO₄)₃F:Sn²⁺, α-Ca₃(PO₄)₂:Eu²⁺, β-Ca₃(PO₄)₂:Eu²⁺, Ca₂P₂O₇:Eu²⁺, Ca₂P₂O₇:Eu²⁺,Mn²⁺, CaP₂O₆:Mn²⁺, α-Ca₃(PO₄)₂:Pb²⁺, α-Ca₃(PO₄)₂:Sn²⁺, β-Ca₃(PO₄)₂:Sn²⁺, β-Ca₂P₂O₇:Sn,Mn, α-Ca₃(PO₄)₂:Tr, CaS:Bi³⁺, CaS:Bi³⁺,Na, CaS:Ce³⁺, CaS:Eu²⁺, CaS:Cu⁺,Na⁺, CaS:La³⁺, CaS:Mn²⁺, CaSO₄:Bi, CaSO₄:Ce³⁺, CaSO₄:Ce³⁺,Mn²⁺, CaSO₄:Eu²⁺, CaSO₄:Eu²⁺,Mn²⁺, CaSO₄:Pb²⁺, CaS:Pb²⁺, CaS:Pb²⁺,Cl, CaS:Pb²⁺,Mn²⁺, CaS:Pr³⁺,Pb²⁺,Cl, CaS:Sb³⁺, CaS:Sb³⁺,Na, CaS:Sm³⁺, CaS:Sn²⁺, CaS:Sn²⁺,F, CaS:Tb³⁺, CaS:Tb³⁺,Cl, CaS:Y³⁺, CaS:Yb²⁺, CaS:Yb²⁺,Cl, CaSiO₃:Ce³⁺, Ca₃SiO₄Cl₂:Eu²⁺, Ca₃SiO₄Cl₂:Pb²⁺, CaSiO₃:Eu²⁺, CaSiO₃:Mn²⁺,Pb, CaSiO₃:Pb²⁺, CaSiO₃:Pb²⁺,Mn²⁺, CaSiO₃:Ti⁴⁺, CaSr₂(PO₄)₂:Bi³⁺, β-(Ca,Sr)₃(PO₄)₂:Sn²⁺Mn²⁺, CaTi_{0.9}Al_{0.1}O₃:Bi³⁺, CaTiO₃:Eu³⁺, CaTiO₃:Pr³⁺, Ca₅(VO₄)₃Cl, CaWO₄, CaWO₄:Pb²⁺, CaWO₄:W, Ca₃WO₆:U, CaYAlO₄:Eu³⁺, CaYBO₄:Bi³⁺, CaYBO₄:Eu³⁺, CaYB_{0.8}O_{3.7}:Eu³⁺, CaY₂ZrO₆:Eu³⁺, (Ca,Zn,Mg)₃(PO₄)₂:Sn, CeF₃, (Ce,Mg)BaAl₁₁O₁₈:Ce, (Ce,Mg)SrAl₁₁O₁₈:Ce, CeMgAl₁₁O₁₉:Ce:Tb, Cd₂B₆O₁₁:Mn²⁺, CdS:Ag⁺,Cr, CdS:In, CdS:In, CdS:In,Te, CdS:Te, CdWO₄, CsF, Csl, CsI:Na⁺, CsI:TI, (ErCl₃)_{0.25}(BaCl₂)_{0.75}, GaN:Zn, Gd₃Ga₅O₁₂:Cr³⁺, Gd₃Ga₅O₁₂:Cr,Ce, GdNbO₄:Bi³⁺, Gd₂O₂S:Eu³⁺, Gd₂O₂Pr³⁺, Gd₂O₂S:Pr,Ce,F, Gd₂O₂S:Tb³⁺, Gd₂SiO₅:Ce³⁺, KAl₁₁O₁₇:TI⁺, KGa₁₁O₁₇:Mn²⁺, K₂La₂Ti₃O₁₀:Eu, KMgF₃:Eu²⁺, KMgF₃:Mn²⁺, K₂SiF₆:Mn⁴⁺, LaAl₃B₄O₁₂:Eu³⁺, LaAlB₂O₆:Eu³⁺, LaAlO₃:Eu³⁺, LaAlO₃:Sm³⁺, LaAsO₄:Eu³⁺, LaBr₃:Ce³⁺, LaBO₃:Eu³⁺, (La,Ce,Tb)PO₄:Ce:Tb, LaCl₃:Ce³⁺, La₂O₃:Bi³⁺, LaOBr:Tb³⁺, LaOBr:Tm³⁺, LaOCl:Bi³⁺, LaOCl:Eu³⁺, LaOF:Eu³⁺, La₂O₃:Eu³⁺, La₂O₃:Pr³⁺, La₂O₂S:Tb³⁺, LaPO₄:Ce³⁺, LaPO₄:Eu³⁺, LaSiO₃Cl:Ce³⁺, LaSiO₃Cl:Ce³⁺,Tb³⁺, LaVO₄:Eu³⁺, La₂W₃O₁₂:Eu³⁺, LiAlF₄:Mn²⁺, LiAl₅O₈:Fe³⁺, LiAlO₂:Fe³⁺, LiAlO₂:Mn²⁺, LiAl₅O₈:Mn²⁺, Li₂CaP₂O₇:Ce³⁺,Mn²⁺, LiCeBa₄Si₄O₁₄:Mn²⁺, LiCeSrBa₃Si₄O₁₄:Mn²⁺, LiInO₂:Eu³⁺, LiInO₂:Sm³⁺, LiLaO₂:Eu³⁺, LuAlO₃:Ce³⁺, (Lu,Gd)₂SiO₅:Ce³⁺, Lu₂SiO₅:Ce³⁺, Lu₂Si₂O₇:Ce³⁺, LuTaO₄:Nb⁵⁺, Lu₁₋ₓYₓAlO₃:Ce³⁺, MgAl₂O₄:Mn²⁺, MgSrAl₁₀O₁₇:Ce, MgB₂O₄:Mn²⁺, MgBa₂(PO₄)₂:Sn²⁺, MgBa₂(PO₄)₂:U, MgBaP₂O₇:Eu²⁺, MgBaP₂O₇:Eu²⁺,Mn²⁺, MgBa₃Si₂O₈:Eu²⁺, MgBa(SO₄)₂:Eu²⁺, Mg₃Ca₃(PO₄)₄:Eu²⁺, MgCaP₂O₇:Mn²⁺, Mg₂Ca(SO₄)₃:Eu²⁺, Mg₂Ca(SO₄)₃:Eu²⁺,Mn², MgCeAlₙO₁₉:Tb³⁺, Mg₄(F)GeO₆:Mn²⁺, Mg₄(F)(Ge,Sn)O₆:Mn²⁺, MgF₂:Mn²⁺, MgGa₂O₄:Mn²⁺, Mg₈Ge₂O₁₁F₂:Mn⁴⁺, MgS:Eu²⁺, MgSiO₃:Mn²⁺, Mg₂SiO₄:Mn²⁺, Mg₃SiO₃F₄:Ti⁴⁺, MgSO₄:Eu²⁺, MgSO₄:Pb²⁺, MgSrBa₂Si₂O₇:Eu²⁺, MgSrP₂O₇:Eu²⁺, MgSr₅(PO₄)₄:Sn²⁺, MgSr₃Si₂O₈:Eu²⁺,Mn²⁺, Mg₂Sr(SO₄)₃:Eu²⁺, Mg₂TiO₄:Mn⁴⁺, MgWO₄, MgYBO₄:Eu³⁺, Na₃Ce(PO₄)₂:Tb³⁺, Nal:TI, Na₁.₂₃K_{O}.₄₂Eu₀.₁₂TiSi₄O₁₁:Eu³⁺, Na_{1.23}K_{0.42}Eu_{0.12}TiSi₅O₁₃·xH₂O:Eu³⁺, Na_{1.29}K_{0.46}Er_{0.08}TiSi₄O₁₁:Eu³⁺, Na₂Mg₃Al₂Si₂O₁₀:Tb, Na(Mg₂₋ₓMnₓ)LiSi₄O₁₀F₂:Mn, NaYF₄:Er³⁺, Yb³⁺, NaYO₂:Eu³⁺, P46(70%) + P47 (30%), SrAl₁₂O₁₉:Ce³⁺, Mn²⁺, SrAl₂O₄:Eu²⁺, SrAl₄O₇:Eu³⁺, SrAl₁₂O₁₉:Eu²⁺, SrAl₂S₄:Eu²⁺, Sr₂B₅O₉Cl:Eu²⁺, SrB₄O₇:Eu²⁺(F,Cl,Br), SrB₄O₇:Pb²⁺, SrB₄O₇:Pb²⁺, Mn²⁺, SrB₈O₁₃:Sm²⁺, SrₓBa_{y}Cl_{z}Al₂O_{4-z/2}: Mn²⁺, Ce³⁺, SrBaSiO₄:Eu²⁺, Sr(Cl,Br,I)₂:Eu²⁺ in SiO₂, SrCl₂:Eu²⁺ in SiO₂, Sr₅Cl(PO₄)₃:Eu, Sr_{w}FₓB₄O_{6.5}:Eu²⁺, Sr_{w}FₓB_{y}O_{z}:Eu²⁺,Sm²⁺, SrF₂:Eu²⁺, SrGa₁₂O₁₉:Mn²⁺, SrGa₂S₄:Ce³⁺, SrGa₂S₄:Eu²⁺, SrGa₂S₄:Pb²⁺, SrIn₂O₄:Pr³⁺, Al³⁺, (Sr,Mg)₃(PO₄)₂:Sn, SrMgSi₂O₆:Eu²⁺, Sr₂MgSi₂O₇:Eu²⁺, Sr₃MgSi₂O₈:Eu²⁺, SrMoO₄:U, SrO·3B₂O₃:Eu²⁺,Cl, ß-SrO·3B₂O₃:Pb²⁺, ß-SrO·3B₂O₃ :Pb²⁺,Mn²⁺, α-SrO·3B₂O₃:Sm²⁺, Sr₆P₅BO₂₀:Eu, Sr₅(PO₄)₃Cl:Eu²⁺, Sr₅(PO₄)₃Cl:Eu²⁺,Pr³⁺, Sr₅(PO₄)₃Cl:Mn²⁺, Sr₅(PO₄)₃Cl:Sb³⁺, Sr₂P₂O₇:Eu²⁺, β-Sr₃(PO₄)₂:Eu²⁺, Sr₅(PO₄)₃F:Mn²⁺, Sr₅(PO₄)₃F:Sb³⁺, Sr₅(PO₄)₃F:Sb³⁺,Mn²⁺, Sr₅(PO₄)₃F:Sn²⁺, Sr₂P₂O₇:Sn²⁺, β-Sr₃(PO₄)₂:Sn²⁺, β-Sr₃(PO₄)₂:Sn²⁺,Mn²⁺(Al), SrS:Ce³⁺, SrS:Eu²⁺, SrS:Mn²⁺, SrS:Cu⁺,Na, SrSO₄:Bi, SrSO₄:Ce³⁺, SrSO₄:Eu²⁺, SrS0₄:Eu²⁺,Mn²⁺, Sr₅Si₄O₁₀Cl₆:Eu²⁺, Sr₂SiO₄:Eu²⁺, SrTiO₃:Pr³⁺, SrTiO₃:Pr³⁺,Al³⁺, Sr₃WO₆:U, SrY₂O₃:Eu³⁺, ThO₂:Eu³⁺, ThO₂:Pr³⁺, ThO₂:Tb³⁺, YAl₃B₄O₁₂:Bi³⁺, YAl₃B₄O₁₂:Ce³⁺, YAl₃B₄O₁₂:Ce³⁺,Mn, YAl₃B₄O₁₂:Ce³⁺,Tb³⁺, YAl₃B₄O₁₂:Eu³⁺, YAl₃B₄O₁₂:Eu³⁺,Cr³⁺, YAl₃BaO₁₂:Th⁴⁺,Ce³⁺,Mn²⁺, YAlO₃:Ce³⁺, Y₃Al₅O₁₂:Ce³⁺, Y₃Al₅O₁₂:Cr³⁺, YAlO₃:Eu³⁺, Y₃Al₅O₁₂:Eu^{3r}, Y₄Al₂O₉:Eu³⁺, Y₃Al₃O₁₂:Mn⁴⁺, YAlO₃:Sm³⁺, YAlO₃:Tb³⁺, Y₃Al₅O₁₂:Tb³⁺, YAsO₄:Eu³⁺, YBO₃:Ce³⁺, YBO₃:Eu³⁺, YF₃:Er³⁺,Yb³⁺, YF₃:Mn²⁺, YF₃:Mn²⁺,Th⁴⁺, YF₃:Tm³⁺,Yb³⁺, (Y,Gd)BO₃:Eu, (Y,Gd)BO₃:Tb, (Y,Gd)₂O₃:Eu³⁺, Y_{1.34}Gd_{0.60}O₃(Eu,Pr), Y₂O₃:Bi³⁺, YOBr:Eu³⁺, Y₂O₃:Ce, Y₂O₃:Er³⁺, Y₂O₃:Eu³⁺(YOE), Y₂O₃:Ce³⁺,Tb³⁺, YOCl:Ce³⁺, YOCl:Eu³⁺, YOF:Eu³⁺, YOF:Tb³⁺, Y₂O₃:Ho³⁺, Y₂O₂S:Eu³⁺, Y₂O₂S:Pr³⁺, Y₂O₂S:Tb³⁺, Y₂O₃:Tb³⁺, YPO₄:Ce³⁺, YPO₄:Ce³⁺,Tb³⁺, YPO₄:Eu³⁺, YPO₄:Mn²⁺,Th⁴⁺, YPO₄:V⁵⁺, Y(P,V)O₄:Eu, Y₂SiO₅:Ce³⁺, YTaO₄, YTaO₄:Nb⁵⁺, YVO₄:Dy³⁺, YVO₄:Eu³⁺, ZnAl₂O₄:Mn²⁺, ZnB₂O₄:Mn²⁺, ZnBa₂S₃:Mn²⁺, (Zn,Be)₂SiO₄:Mn²⁺, Zn_{0.4}Cd_{0.6}S:Ag, Zn_{0.6}Cd_{0.4}S:Ag, (Zn,Cd)S:Ag,Cl, (Zn,Cd)S:Cu, ZnF₂:Mn²⁺, ZnGa₂O₄, ZnGa₂O₄:Mn²⁺, ZnGa₂S₄:Mn²⁺, Zn₂GeOₐ:Mn²⁺, (Zn,Mg)F₂:Mn²⁺, ZnMg₂(PO₄)₂:Mn²⁺, (Zn,Mg)₃(PO₄)₂:Mn²⁺, ZnO:Al³⁺,Ga³⁺, ZnO:Bi³⁺, ZnO:Ga³⁺, ZnO:Ga, ZnO-CdO:Ga, ZnO:S, ZnO:Se, ZnO:Zn, ZnS:Ag⁺,Cl⁻, ZnS:Ag,Cu,Cl, ZnS:Ag,Ni, ZnS:Au,In, ZnS-CdS (25-75), ZnS-CdS (50-50), ZnS-CdS (75-25), ZnS-CdS:Ag,Br,Ni, ZnS-CdS:Ag⁺,Cl, ZnS-CdS:Cu,Br, ZnS-CdS:Cu,I, ZnS:Cl⁻, ZnS:Eu²⁺, ZnS:Cu, ZnS:Cu⁺,Al³⁺, ZnS:Cu⁺,Cl⁻, ZnS:Cu,Sn, ZnS:Eu²⁺, ZnS:Mn²⁺, ZnS:Mn,Cu, ZnS:Mn²⁺,Te²⁺, ZnS:P, ZnS:P³⁻,Cl⁻, ZnS:Pb²⁺, ZnS:Pb²⁺,Cl⁻, ZnS:Pb,Cu, Zn₃(PO₄)₂:Mn²⁺, Zn₂SiO₄:Mn²⁺, Zn₂SiO₄:Mn²⁺,As⁵⁺, Zn₂SiO₄:Mn,Sb₂O₂, Zn₂SiO₄:Mn²⁺,P, Zn₂SiO₄:Ti⁴⁺, ZnS:Sn²⁺, ZnS:Sn,Ag, ZnS:Sn²⁺,Li⁺, ZnS:Te,Mn, ZnS-ZnTe:Mn²⁺, ZnSe:Cu⁺,Cl, ZnWO₄

Dabei ist es in einer erfindungsgemäßen Ausführungsform bevorzugt, wenn die Lichtquelle neben dem erfindungsgemäßen Leuchtstoff einen grün emittierenden Leuchtstoff enthält. Entsprechende Leuchtstoffe sind dem Fachmann bekannt bzw. kann der Fachmann aus der oben aufgeführten Liste auswählen. Erfindungsgemäß bevorzugte grün emittierende Leuchtstoffe sind dabei zum einen Barium-haltige Orthosilikatleuchtstoffe und zum anderen Luthethium-haltige Granat-Leuchtstoffe.

In einer besonders bevorzugten Ausführungsform ist es wiederum bevorzugt, wenn die Leuchtstoffe so auf der Primärlichtquelle angeordnet sind, dass der erfindungsgemäße Leuchtstoff im wesentlichen von Licht der Primärlichtquelle angestrahlt wird, während der grün emittierende Leuchtstoff im wesentlichen von Licht angestrahlt wird, welches bereits den rot emittierenden Leuchtstoff passiert hat bzw. von diesem gestreut wurde. Dies kann realisiert werden, indem der erfindungsgemäße Leuchtstoff zwischen Primärlichtquelle und dem grün emittierenden Leuchtstoff angebracht wird.

Die erfindungsgemäßen Leuchtstoffe bzw. Leuchtstoffkombinationen können entweder in einem Harz dispergiert (z.B. Epoxy- oder Siliconharz), oder bei geeigneten Größenverhältnissen direkt auf der Primärlichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005). L649-L651.

In einer weiteren Ausführungsform ist es bevorzugt, wenn die optische Ankopplung zwischen dem Leuchtstoff und der Primärlichtquelle durch eine lichtleitende Anordnung realisiert wird. Dadurch ist es möglich, dass an einem zentralen Ort die Primärlichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Primärlichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Weitere Erfindungsgegenstände sind eine Beleuchtungseinheit, insbesondere zur Hintergrundbeleuchtung von Anzeigevorrichtungen, dadurch gekennzeichnet, dass sie mindestens eine erfindungsgemäße Lichtquelle enthält, sowie eine Anzeigevorrichtung, insbesondere Flüssigkristallanzeigevorrichtung (LC Display), mit einer Hintergrundbeleuchtung, dadurch gekennzeichnet, dass sie mindestens eine erfindungsgemäße Beleuchtungseinheit enthält.

Ein weiterer Aspekt der vorliegenden Erfindung betrifft eine elektronische oder elektrooptische Vorrichtung enthaltend eine oder mehrere Leuchtstoffe wie vor- und nachstehend beschrieben. Ein weiterer Aspekt betrifft die Verwendung der Leuchtstoffe wie vor- und nachstehend beschrieben in einer elektronischen oder elektrooptischen Vorrichtung. Bei der elektronischen oder elektrooptischen Vorrichtung kann es sich beispielsweise auch um einen organischen Feldeffekttransistor (organic field effect transistor - OFET), einen Dünnfilmtransistor (thin film transistor - TFT), eine organische Solarzelle (organic solar cell - O-SC), eine organische Laserdiode (organic laser diode - O-laser), eine organische integrierte Schaltung (organic integrated circuit - 0-IC), ein RFID (radio frequency identification)-Tag, einen Photodetektor, einen Sensor, eine logische Schaltung, ein Speicherelement, einen Kondensator, eine Ladungsinjektionsschicht, eine Schottky-Diode, eine Planarisierungsschicht, eine Antistatikfolie, ein leitendes Substrat oder eine leitende Struktur, einen Photoleiter, ein elektrophotographisches Element oder einen organischen lichtemittierenden Transistor (organic light emitting transistor - OLET) handeln.

Die Partikelgröße der erfindungsgemäßen Leuchtstoffe beträgt bei Einsatz in LEDs zwischen 50 nm und 30 µm, vorzugsweise zwischen 1 µm und 20 µm.

Zum Einsatz in LED können die Leuchtstoffe auch in beliebige äußere Formen, wie sphärische Partikel, Plättchen und strukturierte Materialien und Keramiken, überführt werden. Diese Formen werden erfindungsgemäß unter dem Begriff "Formkörper" zusammengefasst. Vorzugsweise handelt es sich bei dem Formkörper um einen "Leuchtstoffkörper". Ein weiterer Gegenstand der vorliegenden Erfindung ist somit ein Formkörper enthaltend die erfindungsgemäßen Leuchtstoffe.

In einer weiteren bevorzugten Ausführungsform besitzt der Leuchtstoffformkörper auf der, einem LED Chip entgegengesetzten Seite eine strukturierte (z.B. pyramidale) Oberfläche (siehe DE 102006054330), die voll umfänglich in den Kontext der vorliegenden Anmeldung durch Bezugnahme eingefügt wird). Somit kann möglichst viel Licht aus dem Leuchtstoff ausgekoppelt werden. Die strukturierte Oberfläche auf dem Leuchtstoff kann durch nachträgliches Beschichten mit einem geeigneten Material, welches bereits strukturiert ist, oder in einem nachfolgenden Schritt durch (photo-) lithografische Verfahren, Ätzverfahren oder durch Schreibverfahren mit Energie- oder Materiestrahlen oder Einwirkung von mechanischen Kräften hergestellt werden.

In einer weiteren bevorzugten Ausführungsform besitzen die erfindungsgemäßen Leuchtstoffformkörper auf der, einem LED Chip entgegen-gesetzten Seite eine raue Oberfläche, die Nanopartikel aus SiO₂, TiO₂, Al₂O₃, ZnO₂, ZrO₂ und/oder Y₂O₃ oder Kombinationen aus diesen Materialien oder aus Partikeln mit der Leuchtstoffzusammensetzung trägt. Dabei hat eine raue Oberfläche eine Rauhigkeit von bis zu einigen 100 nm. Die beschichtete Oberfläche hat den Vorteil, dass Totalreflexion verringert oder verhindert werden kann und das Licht besser aus dem erfindungsgemäßen Leuchtstoff ausgekoppelt werden kann (siehe DE 102006054330), die voll umfänglich in den Kontext der vorliegenden Anmeldung durch Bezugnahme eingefügt wird.)

Weiterhin bevorzugt ist es, wenn die erfindungsgemäßen Leuchtstoffformkörper auf der dem Chip abgewandten Oberfläche eine Brechzahl angepasste Schicht besitzen, welche die Auskopplung der Primärstrahlung und oder der vom Leuchtstoffkörper emittierten Strahlung erleichtert.

In einer weiteren bevorzugten Ausführungsform besitzen die Leuchtstoffe eine geschlossene Oberflächenbeschichtung, die aus SiO₂, TiO₂, Al₂O₃, ZnO, ZrO₂ und/oder Y₂O₃ oder Mischoxide daraus besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächebeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt kann es sein, wenn die Leuchtstoffe eine poröse Oberflächenbeschichtung besitzen, die aus SiO₂, TiO₂, Al₂O₃, ZnO, ZrO₂ und/oder Y₂O₃ oder Mischoxide daraus oder aus der Leuchtstoffzusammensetzung besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Ausführungsform besitzen die Leuchtstoffe eine Oberfläche, die funktionelle Gruppen trägt, welche eine chemische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Da die auf dem LED Chip aufgebrachte erfindungsgemäße Leuchtstoffschicht vorzugsweise aus einem Gemisch von Silikon und Leuchtstoffpartikeln besteht, und das Silikon eine Oberflächenspannung aufweist, ist diese Leuchtstoffschicht auf mikroskopischer Ebene nicht einheitlich bzw. ist die Dicke der Schicht nicht durchweg konstant.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und DE 102006054331 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht.

Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm.

Er besitzt in der Regel ein Aspektverhältnis (Verhältnis des Durchmessers zur Teilchendicke) von 1 : 1 bis 400 : 1, und insbesondere 3 : 1 bis 100 : 1.

Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.

Die dem LED Chip zugewandte Oberfläche des erfindungsgemäßen plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.

Hierfür eignen sich beispielsweise brechzahlangepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der erfindungsgemäßen Leuchtstoffe in Form von keramischen Körpern kann analog nach dem in der DE 102006037730 (Merck) beschrieben Verfahren, die voll umfänglich in den Kontext der vorliegenden Anmeldung durch Bezugnahme eingefügt wird, erfolgen. Dabei wird der Leuchtstoff durch Mischen der entsprechenden Edukte und Dotierstoffe nasschemisch hergestellt, anschließend isostatisch verpresst und in Form eines homogenen dünnen und nicht porösen Plättchens direkt auf die Oberfläche des Chips aufgebracht. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneider der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.

Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.

Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

Auch ohne weitere Ausführungen wird davon ausgegangen, dass ein Fachmann die obige Beschreibung in weitestem Umfang nutzen kann. Die bevorzugten Ausführungsformen sind deswegen lediglich als beschreibende, keinesfalls als in irgendeiner Weise limitierende Offenbarung aufzufassen. Die vollständige Offenbarung aller vor- und nachstehend aufgeführten Anmeldungen und Veröffentlichungen sind durch Bezugnahme in diese Anmeldung eingeführt. Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden.

### Beispiele

### Beispiel 1: Herstellung unterschiedlicher Zusammensetzungen der Mischung (Ca,Sr,Ba)_{2-0,5y-x}Si₅N_{8-y}O_{y}:Eu(II)ₓ * SiO₂

### Beispiel 1A: Sr_{1,6}Si₅N_{7,6}O_{0,4}:Eu(II)_{0,2}* 2,1 SiO₂

4.2203 g (14.51 mmol) Sr₃N₂, 0.3074 g (1.85 mmol) EuN, 0.1163 g (0.92 mmol) SrF₂ und 1.3911 g (23.15 mmol) SiO₂ werden in einer Glovebox in einem Achatmörser gründlich vermischt. Die Mischung wird in einen Korundtiegel gefüllt, der mit einer Molybdänfolie bedeckt wird und in einen Ofen überführt. Dort wird die Mischung über 8 h bei einer Temperatur von 1600 °C im N₂/H₂/NH₃ Strom geglüht. Danach wird das Material entnommen und 3 h lang in 1 molarer HCl-lösung gewaschen, abgesaugt, mit Wasser nachgewaschen und getrocknet.

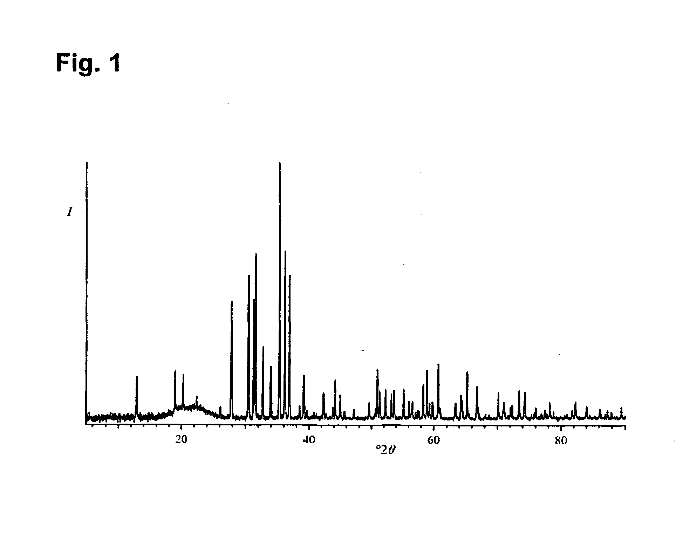

Elementaranalyse zeigt, dass das Material ein geringeres Sr/Si-Verhältnis aufweist als Sr₂Si₅N₈ und signifikante Mengen Sauerstoff enthält. Das Material wurde in einem Pulver-Röntgendiffraktometer (Figur 1) vermessen und die Kristallstruktur mittels Rietveld-Verfeinerung ausgehend vom Kristallstrukturtyp von Sr₂Si₅N₈ bestimmt. Für die Aufnahme der Pulver-Röntgendiffraktogramme wurde ein Transmission Powder X-Ray Diffraktometer StadiP 611 KL der Fa. Stoe & Cie. GmbH eingesetzt. Die Röntgenröhre emittierte Cu-Kα1-Strahlung, es wurde ein Germanium [111] fokussierender Primärstrahlmonochromator, und ein linearer PSD-Detektor verwendet.

Die Rietveld-Verfeinerung wurde mit dem Programm GSAS (A.C. Larson and R.B. Von Dreele, General Structure Analysis System (GSAS), Los Alamos National Laboratory Report LAUR, 2004, 86-748) mit einem Thompson, Cox und Hastings Pseudo-Voigt (P. Thompson, D.E. Cox and J.B. Hastings, J. Appl. Cryst.,20, 1987, 79-83) Reflexprofil inklusive Korrektur der Asymmetrie ("Umbrella Effekt") nach Finger, Cox und Jephcoat (L.W. Finger, D.E. Cox and A. P. Jephcoat, J. Appl. Cryst.,27, 1994, 892-900) durchgeführt. Hierzu wurden zunächst die Gitterkonstanten, der Nullpunkt, der Untergrund (inklusive amorphem Anteil) und das Reflexprofil in einer modellfreien LeBail-Verfeinerung angepasst und die Parameter des Untergrundes und des Reflexprofils bei der anschließenden Rietveld-Verfeinerung konstant gehalten. Für das Strukturmodell wurde der aus der Elementanalytik erhaltene Anteil Europium entsprechend Anteilig auf die Strontium-Atompositionen gesetzt und dort festgehalten. Alle Atompositionen und die zugehörigen isotropen Auslenkungsparameter wurden frei verfeinert. Der Besetzungsfaktor Europium wurde an den Besetzungsfaktor der Strontiumpositionen gekoppelt und frei verfeinert. Reproduzierbar wurde die Summe der Besetzungsfaktoren Strontium und Europium zu Werten kleiner 100 % verfeinert. Die Unterschiede des gemessen Diffraktogramms zum berechneten Diffraktogramm mit vollständiger Besetzung der Sr/Eu-Position lassen sich nicht durch andere Effekte wie Vorzugsorientierung in der Probe (sog. Textureffekt) erklären. Eine Vorzugsorientierung tritt nur bei ausgeprägter Morphologie der Probe auf, die Ergebnisse einer Rasterelektronenmokroskopischen Aufnahme geben darauf jedoch keinen Hinweis. Das Probenmaterial besteht aus Partikeln unregelmäßiger Morphologie im Bereich weniger Mikrometer. Das Material wurde zudem vor der Messung im Mörser zerkleinert. Der Test einer Verfeinerung der Vorzugsorientierung mit einem Spherical-Harmonics-Modell vierter Ordnung ergab praktisch keine Vorzugsorientierung. Aus diesem Grund wurde sie bei der Bestimmung der Sr-Defekte nicht verfeinert. Die Verfeinerung der Atompositionen führte nur zu geringen Verschiebungen, sodass das Strukturmodell weiterhin chemisch und physikalisch sinnvoll ist. Dies und die Übereinstimmung des berechneten mit dem gemessenen Diffraktogramm beweist die Korrektheit des Strukturmodells, also der bestimmten Kristallstruktur mit entsprechender Besetzung der einzelnen Atompositionen.

Der amorphe Anteil der Materialien wurde mit dem Untergrund des Röntgen-Diffraktogramms abgezogen und spielt für die Bestimmung daher keine Rolle. Die

Rietveld-Analytik liefert insofern selektiv die elementare Zusammensetzung und Kristallstruktur der kristallinen Phase. Eine Abschätzung des amorphen Anteils aus den Flächenverhältnissen im Diffraktogramm korreliert mit den Ergebnissen der Elementanalytik.

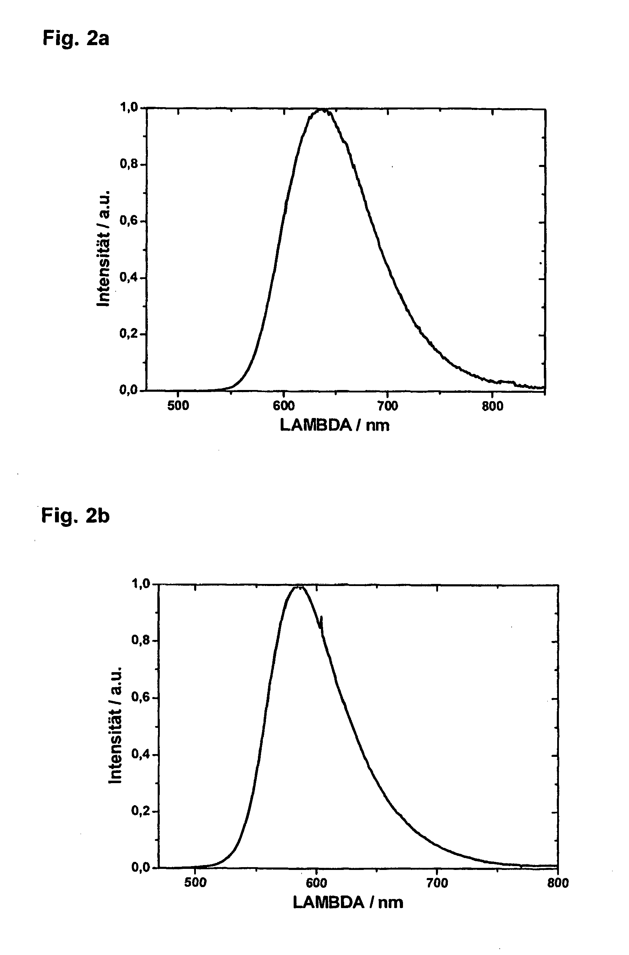

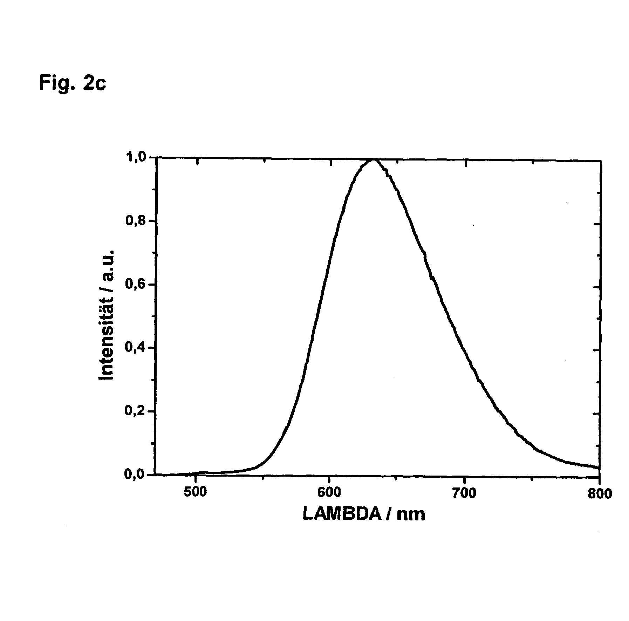

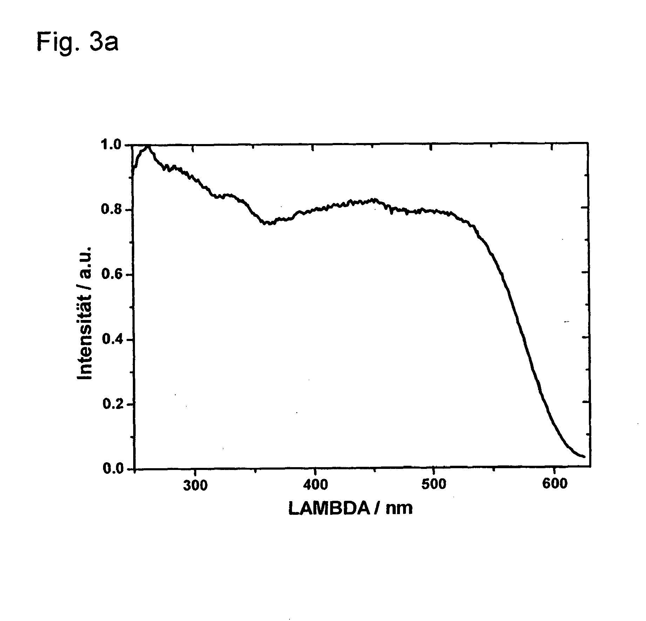

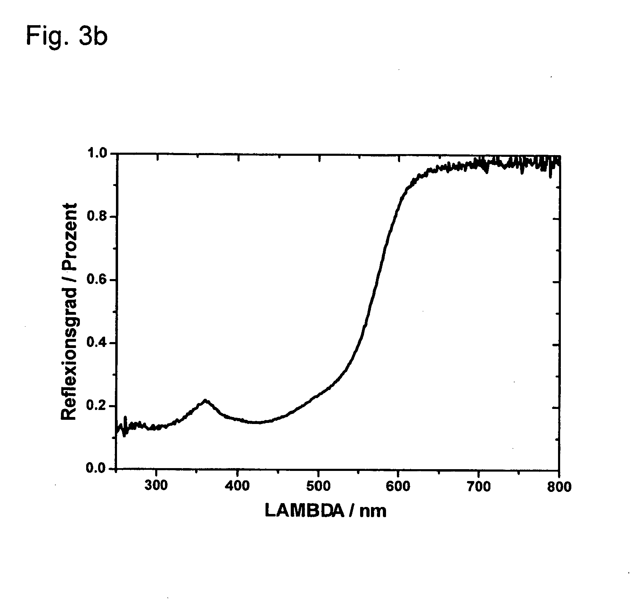

Das resultierende Produkt zeigt das Fluoreszenzspektrum gemäß Figur 2, das Anregungsspektrum gemäß Figur 3a und das Reflexionsspektrumgemäß Figur 3b.

### Beispiel 1B: Synthese von Sr_{1.5}Si₅N_{7,6}O_{0,4}:Eu(II)_{0,3} * 2,3 SiO₂

4.0257 g (13.84 mmol) Sr₃N₂, 0.5301 g (3.19 mmol) EuN, 0.1146 g (0.91 mmol) SrF₂ und 1.3707 g (22.81 mmol) SiO₂werden in einer Glovebox in einem Achatmörser gründlich vermischt. Die Mischung wird in einen Korundtiegel gefüllt, der mit einer Molybdänfolie bedeckt wird und in einen Ofen überführt. Dort wird die Mischung über 8 h bei einer Temperatur von 1600 °C im N₂/H₂/NH₃ Strom geglüht. Danach wird das Material entnommen und 3 h lang in 1 molarer HCl-lösung gewaschen, abgesaugt, mit Wasser nachgewaschen und getrocknet.

Die Strukturbestimmung erfolgte, wie bei Beispiel 1A beschrieben und ergab die angegebene Zusammensetzung.

### Beispiel 1C: Synthese von Sr_{1,4}Si₅N_{7,6}O_{0,4}:Eu_{0,4} * 2,8 SiO₂

3.8366 g (13.19 mmol) Sr₃N₂, 0.7463 g (4.50 mmol) EuN, 0.1130 g (0.90 mmol) SrF₂ und 1.3509 g (22.48 mmol) SiO₂ werden in einer Glovebox in einem Achatmörser gründlich vermischt. Die Mischung wird in einen Korundtiegel gefüllt, der mit einer Molybdänfolie bedeckt wird und in einen Ofen überführt. Dort wird die Mischung über 8 h bei einer Temperatur von 1600 °C im N₂/H₂/NH₃ Strom geglüht. Danach wird das Material entnommen und 3 h lang in 1 molarer HCl-lösung gewaschen, abgesaugt, mit Wasser nachgewaschen und getrocknet.

Die Strukturbestimmung erfolgte, wie bei Beispiel 1A beschrieben und ergab die angegebene Zusammensetzung.

### Beispiel 1D: Synthese von Ba_{1,76}Si₅N_{7,6}O_{0,4}:Eu_{0,04}

6,453 g (14,66 mmol) Ba₃N₂, 0,166 g (1 mmol) EuN, 5,666 g (39,583 mmol) Si₃N₄ und 0,376 g (6,25 mmol) SiO₂ werden in einer Glovebox in einem Achatmörser gründlich vermischt. Die Mischung wird in einen Korundtiegel gefüllt, der mit einer Molybdänfolie bedeckt wird und in einen Ofen überführt. Dort wird die Mischung über 8 h bei einer Temperatur von 1600 °C im N₂/H₂/NH₃ Strom geglüht. Danach wird das Material entnommen und 3 h lang in 1 molarer HCl-lösung gewaschen, abgesaugt, mit Wasser nachgewaschen und getrocknet.

Die Strukturbestimmung erfolgte, wie bei Beispiel 1A beschrieben und ergab die angegebene Zusammensetzung.

### Beispiel 1 E: Synthese von Ca_{0,35}Sr_{1,41}Si₅N_{7,6}O_{0,4}:Eu_{0,04}

3.42 g (11,76 mmol) Sr₃N₂, 0,43 g (2,92 mmol) Ca₃N₂, 0,166 g (1 mmol) EuN, 5,666 g (39,583 mmol) Si₃N₄ und 0,376 g (6,25 mmol) SiO₂ werden in einer Glovebox in einem Achatmörser gründlich vermischt. Die Mischung wird in einen Korundtiegel gefüllt, der mit einer Molybdänfolie bedeckt wird und in einen Ofen überführt. Dort wird die Mischung über 8 h bei einer Temperatur von 1600 °C im N₂/H₂/NH₃ Strom geglüht. Danach wird das Material entnommen und 3 h lang in 1 molarer HCl-lösung gewaschen, abgesaugt, mit Wasser nachgewaschen und getrocknet.

Die Strukturbestimmung erfolgte, wie bei Beispiel 1A beschrieben und ergab die angegebene Zusammensetzung.

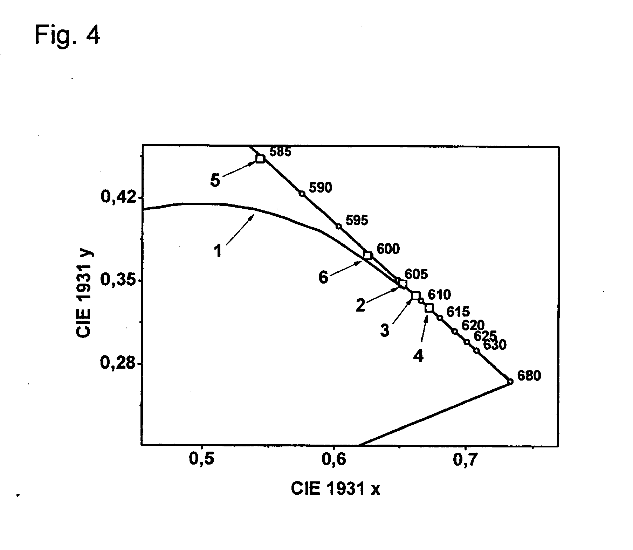

In Figur 4 sind die Farbpunkte der Leuchtstoffe aus Beispiel 1A (2), Beispiel 1 B (3), Beispiel 1C (4), Beispiel 1D (5) und Beispiel 1E (6) im CIE 1931 Farbdiagramm mit der Planck'schen Kurve für den idealen Schwarzstrahler (1) eingetragen.

### Beispiel 1F: Isolierung von Sr_{1,6}Si₅N_{7,6}O_{0,4}:Eu(II)_{0,2} * 2,1 SiO₂

Unter dem Mikroskop werden aus der Probe aus Beispiel 1A Kristalle von glasartigen Anteilen getrennt. Bei dem kristallinen Anteil handelt es sich um die Verbindung Sr_{1,6}Si₅N_{7,6}O_{0,4}:Eu(II)_{0,2} * 2,1 SiO₂.

### Beispiel 2: LED Applikation der Leuchtstoffe

Verschiedene Konzentrationen des Leuchtstoffes werden in dem Silikonharz OE 6550 der Fa. Dow Corning hergestellt, indem 5 ml der Komponenten A und 5 ml der Komponenten B des Silikons mit identischen Mengen des Leuchtstoffes gemischt werden, so dass nach Vereinigung der beiden Dispersionen A und B durch Homogenisierung mit einem Speedmixer die folgenden Silikonleuchtstoffmischungsverhältnisse vorhanden sind:
5 Gew.-% Leuchtstoff,
10 Gew.-% Leuchtstoff,
15 Gew.-% Leuchtstoff und
30 Gew.-% Leuchtstoff.

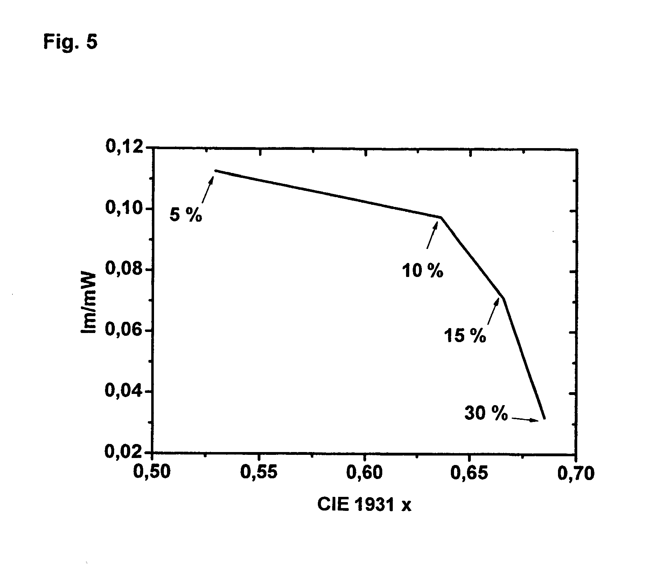

Diese Mischungen werden jeweils in einen Dispenser der Fa. Essemtek überführt und in leere LED-3528-packages der Fa. Mimaki Electronics gefüllt. Nach Aushärtung des Silikons bei 150°C über 1 h werden die LEDs lichttechnisch charakterisiert mit Hilfe eines Aufbaus, bestehend aus Komponenten der Fa. Instrument Systems: Spektrometer CAS 140 und Integrationskugel ISP 250. Für die Messung werden die LEDs mit einer regelbaren Stromquelle der Fa. Keithley bei Raumtemperatur mit einer Stromstärke von 20 mA kontaktiert. In Figur 5 ist die Helligkeit (in Lumen der konvertierten LED / mW optischer Leistung des blauen LED Chips) gegen Farbpunkt CIE x der konvertierten LED in Abhängigkeit der Leuchtstoff-Einsatzkonzentration im Silikon (5, 10, 15 und 30 Gew.-%) aufgetragen.

Das Lumenäquivalent ist eine dem Fachmann geläufige lichttechnische Größe mit der Einheit Im/W, die beschreibt, wie groß der photometrische Lichtstrom in Lumen einer Lichtquelle bei einer bestimmten radiometrischen Strahlungsleistung mit der Einheit Watt, ist. Je höher das Lumenäquivalent ist, desto effizienter ist eine Lichtquelle.

Das Lumen ist eine dem Fachmann geläufige, photometrische lichttechnische Größe, welche den Lichtstrom einer Lichtquelle, der ein Maß für die gesamte von einer Strahlungsquelle ausgesandte sichtbare Strahlung ist, beschreibt. Je größer der Lichtstrom, desto heller erscheint die Lichtquelle dem Beobachter.

CIE x und CIE y stehen für die Koordinaten im dem dem Fachmann geläufigen CIE Normfarbdiagramm (hier Normalbeobachter 1931), mit denen die Farbe einer Lichtquelle beschrieben wird.

Alle oben aufgeführten Größen werden nach dem Fachmann geläufigen Methoden aus Emissionsspektren der Lichtquelle berechnet.

### Beispiel 3: Herstellung des Leuchtstoffes Lu_{2,97}Al₅O₁₂:Ce_{0,03} ("LuAG")

387 g Ammoniumhydrogencarbonat werden innerhalb von 1 h in 4,3 Litern VE-Wasser gelöst. In 2,71 VE-Wasser werden 148 g Aluminiumchlorid-Hexahydrat, 135 g Lutetiumchlorid-Hexahydrat, und 0,86 g Cerchlorid Heptahydrat gelöst und innerhalb von 0,75h zur Hydrogencarbonatlösung zugetropft. Die Hydrogencarbonatlösung wird auf pH 8 eingestellt. Der anfallende Niederschlag wird abgesaugt und gewaschen. Danach wird er getrocknet und in einen Ofen überführt.

Der Niederschlag wird 2 Stunden bei 1000°C an Luft vorkalziniert und anschließend 6 Stunden bei 1700 °C reduktiv kalziniert. Das Emissionsspektrum der Verbindung ist in Figur 1 angegeben.

### Beispiel 4: Herstellung von Leuchtstoffmischungen

10 g Lu_{2,97}Al₅O₁₂:Ce_{0,03} ("LuAG") werden mit 1 g des Leuchtstoffes aus Beispiel 1A innig vermischt.

### Beispiel 5: Herstellung einer Leuchtdiode ("LuAG-Beispiel1A")

Die Leuchtstoffmischung aus Beispiel 4 wird in einem Taumelmischer mit einem 2-Komponenten Silikon (OE 6550 der Fa. Dow Corning) gemischt, so dass gleiche Mengen der Leuchtstoffmischung in den beiden Komponenten des Silikons dispergiert sind; die Gesamtkonzentration der Leuchtstoffmischung im Silikon beträgt 8 Gew.-%.

5 ml jeder der beiden Leuchtstoff enthaltenden Silikon Komponenten werden homogen miteinander gemischt und in einen Dispenser überführt. Mit Hilfe des Dispensers werden leere LED packages von der Fa. OSA optoelectronics, Berlin, welche einen 100 µm2 großen GaN Chip enthalten, befüllt. Danach werden die LEDs in eine Wärmekammer gestellt, um über 1 h bei 150°C das Silikon zu verfestigen.

### Beispiel 6: Herstellung einer Leuchtdiode in welcher die Leuchtstoffe so auf der Primärlichtquelle angeordnet sind, dass der rot emitterende Leuchtstoff im wesentlichen von Licht der Primärlichtquelle angestrahlt wird, während der grün emittierende Leuchtstoff im wesentlichen von Licht angestrahlt wird, welches bereits den rot emittierenden Leuchtstoff passiert hat bzw. von diesem gestreut wurde

Der Leuchtstoff aus Beispiel 1A bzw. LuAG wird in einem Taumelmischer mit einem 2-Komponenten Silikon (OE 6550 der Fa. Dow Corning) gemischt, so dass gleiche Mengen der Leuchtstoffmischung in den beiden Komponenten des Silikons dispergiert sind. Die Konzentration des grünen Leuchtstoffes im Silikon beträgt 8 Gew.-% LuAG (Pre-Mix A) bzw. 1 Gew.-% Leuchtstoff gemäß Beispiel 1A (Pre-Mix B).

5 ml jeder der beiden Leuchtstoff enthaltenden Silikon Komponenten eines pre-Mixes werden homogen miteinander gemischt und in einen Dispenser überführt. Mit Hilfe des Dispensers werden leere LED packages von der Fa. OSA optoelectronics, Berlin, welche einen 100 µm2 großen GaN Chip enthalten, befüllt. Zuerst wird der Pre-Mix B eingefüllt. Danach werden die LEDs in eine Wärmekammer gestellt, um über 1 h bei 150°C das Silikon zu verfestigen. Anschließend wird Premix A eingefüllt und erneut in der Wärmekammer das Silikon verfestigt.

Die Beispiele 2, 4, 5 und 6 können analog auch mit Leuchtstoffen gemäß Beispielen 1 B bis 1 E oder anderen erfindungsgemäßen Leuchtstoffen durchgeführt werden.

### Beschreibung der Figuren

**Figur 1****:** Pulver-Röntgendiffraktogramm von Beispiel 1A, gemessen auf einem Transmission Powder X-Ray Diffraktometer StadiP 611 KL der Fa. Stoe & Cie. GmbH, Cu-Kα1-Strahlung, Germanium [111] fokussierender Primärstrahlmonochromator, linearer PSD-Detektor.
**Figur 2a****:** Fluoreszenzspektrum des Produktes aus Beispiel 1A, aufgenommen mit einem Edinburgh Instruments Spektrometer FS920 bei einer Anregungswellenlänge von 450 nm (Peakwellenlänge: 635 nm). Bei der Fluoreszenzmessung wird der Anregungsmonochromator auf die Anregungswellenlänge eingestellt und der nach der Probe angeordnete Detektormonochromator in 1 nm Schritten zwischen 550 und 850 nm gescannt, wobei die den Detektormonochromator passierende Lichtintensität gemessen wird.
**Figur 2b****:** Fluoreszenzspektrum des Produktes aus Beispiel 1 D, die Messmethodik ist analog zu 2a
**Figur 2c****:** Fluoreszenzspektrum des Produktes aus Beispiel 1 E, die Messmethodik ist analog zu 2a
**Figur 3a****:** Anregungsspektrum des Produktes aus Beispiel 1A, aufgenommen mit einem Edinburgh Instruments Spektrometer FS920. Bei der Anregungsmessung wird der Anregungsmonochromator in 1 nm Schritten zwischen 250 nm und 610 nm gescannt, während das Fluoreszenzlicht der Probe konstant ab einer Wellenlänge von 610 nm detektiert wird.
**Figur 3b****:** Reflexionsspektrum des Produktes aus Beispiel 1A, aufgenommen mit einem Edinburgh Instruments Spektrometer FS920. Bei der Reflektionsmessung wird die Probe in einer Intergationskugel fixiert und der Anregungsmonochromator sowie der Detektormonochromator synchron über einen Wellenlängenbereich von 250 - 800 nm in 1 nm Schritten gescannt, wobei die den Detekormonochromator passierende Lichtintensität gemessen wird. Das gleiche Prozedere wird an BaSO₄-Pulver (als Reflektionsstandard) durchgeführt. Danach werden beide erhaltene Spektren miteinander multipliziert, wobei das quantitative Reflektionsspektrum der Probe erhalten wird.
**Figur 4****:** CIE 1931 Farbdiagramm mit der Planck'schen Kurve (1) und den Farbpunkten der Leuchtstoffe aus Beispiel 1A (2), Beispiel 1B (3), Beispiel 1C (4), Beispiel 1D (5) und Beispiel 1 E (6).
**Figur 5****:** Lichttechnische Charakterisierung der LED aus Beispiel 2. Erstellt mit Hilfe eines Aufbaus, bestehend aus Komponenten der Fa. Instrument Systems: Spektrometer CAS 140 und Integrationskugel ISP 250. Für die Messung werden die LEDs mit einer regelbaren Stromquelle der Fa. Keithley (Modell 2600) bei Raumtemperatur mit einer Stromstärke von 20 mA kontaktiert. Aufgetragen ist die Helligkeit (in Lumen der konvertierten LED / mW optischer Leistung des blauen LED chips) gegen Farbpunkt CIE x der konvertierten LED in Abhängig der Leuchtstoff-Einsatzkonzentration im Silikon (5, 10, 15 und 30 Gew.-%).

## Patentansprüche

1. Verbindung der Formel I,
A_{2-0,5y-x} Euₓ Si₅ N_{8-y} O_{y} (I)
wobei
A für ein oder mehrere Elemente ausgewählt aus Ca, Sr, Ba steht und
x für einen Wert aus dem Bereich von 0,005 bis 1 steht und
y für einen Wert aus dem Bereich von 0,1 bis 2,5 steht,
**dadurch gekennzeichnet, dass** die Verbindung zusammen mit mindestens einer weiteren Silicium und Sauerstoff enthaltende Verbindung vorliegt, die röntgenamorph oder glasartig ist.

2. Verbindung nach Anspruch 1, **dadurch gekennzeichnet, dass** A für Sr steht.

3. Verbindung nach einem oder mehreren der Ansprüche 1 oder 2, dadurch gekennzeichnt, dass x für einen Wert aus dem Bereich von 0,01 bis 0,8, vorzugsweise aus dem Bereich 0,02 bis 0,7 und insbesondere bevorzugt aus dem Bereich 0,05 bis 0,6 steht.

4. Verbindung nach einem oder mehreren der Ansprüche 1 bis 3, dadurch gekennzeichnt, dass y für einen Wert aus dem Bereich von 0,2 bis 2 steht und bevorzugt aus dem Bereich von 0,22 bis 1,8.

5. Mischung enthaltend mindestens eine Verbindung der Formel I,
A_{2-0,5y-x} Euₓ Si₅ N_{8-y} O_{y} (I)
wobei
A für ein oder mehrere Elemente ausgewählt aus Ca, Sr, Ba steht und
x für einen Wert aus dem Bereich von 0,005 bis 1 steht und
y für einen Wert aus dem Bereich von 0,1 bis 2,5 steht und mindestens eine weitere Silicium und Sauerstoff enthaltende Verbindung, **dadurch gekennzeichnet, dass** die Silicium und Sauerstoff enthaltende Verbindung röntgenamorph oder glasartig ist.

6. Mischung nach Anspruch 5, **dadurch gekennzeichnet, dass** die Verbindung der Formel I in der Mischung zu einen Gewichtsanteil aus dem Bereich von 30 - 95 Gew.-%, vorzugsweise aus dem Bereich von 50 - 90 Gew.-% und insbesondere bevorzugt aus dem Bereich von 60 - 88 Gew.-% enthalten ist.

7. Mischung nach einem oder mehreren der Ansprüche 5 oder 6, **dadurch gekennzeichnet, dass** die Mischung erhältlich ist, durch ein Verfahren, bei dem in einem Schritt a) geeignete Edukte ausgewählt aus binären Nitriden, Halogeniden und Oxiden dazu gemischt werden und das Gemisch in einem Schritt b) unter reduktiven Bedingungen thermisch behandelt wird.

8. Verfahren zur Herstellung einer Verbindung gemäß einem oder mehreren der Ansprüche 1 bis 4 bzw. einer Mischung gemäß einem oder mehreren der Ansprüche 5 bis 7, **dadurch gekennzeichnet, dass** in einem Schritt a) geeignete Edukte ausgewählt aus binären Nitriden, Halogeniden und Oxiden dazu gemischt werden und das Gemisch in einem Schritt b) unter reduktiven Bedingungen thermisch behandelt wird.

9. Verfahren nach Anspruch 8, **dadurch gekennzeichnet, dass** im Schritt b) die Umsetzung bei einer Temperatur oberhalb 800 C, vorzugsweise bei einer Temperatur oberhalb 1200°C und insbesondere bevorzugt im Bereich von 1400°C -1800°C erfolgt.

10. Verfahren nach einem oder mehreren der Ansprüche 8 oder 9, **dadurch gekennzeichnet, dass** der Schritt b) im Stickstoffstrom, vorzugsweise im N₂/H₂-Strom und insbesondere bevorzugt im N₂/H₂/NH₃-Strom erfolgt.

11. Lichtquelle mit mindestens einer Primärlichtquelle, **dadurch gekennzeichnet, dass** die Lichtquelle mindestens einen Leuchtstoff nach Formel I gemäß einem oder mehreren der Ansprüche 1 bis 4 oder eine Mischung gemäß einem oder mehreren der Ansprüche 5 bis 7 enthält.

12. Lichtquelle nach Anspruch 11, **dadurch gekennzeichnet, dass** es sich bei der Primärlichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 handelt.

13. Lichtquelle nach einem oder mehreren der Ansprüche 11 oder 12, **dadurch gekennzeichnet, dass** die Lichtquelle einen grün emittierenden Leuchtstoff enthält.

14. Lichtquelle nach einem oder mehreren der Ansprüche 11 bis 13, **dadurch gekennzeichnet, dass** die Leuchtstoffe so auf der Primärlichtquelle angeordnet sind, dass der Leuchtstoff gemäß Formel I im wesentlichen von Licht der Primärlichtquelle angestrahlt wird, während der grün emitterende Leuchtstoff im wesentlichen von Licht angestrahlt wird, welches bereits den rot emittierenden Leuchtstoff passiert hat bzw. von diesem gestreut wurde.

15. Lichtquelle nach Anspruch 14, **dadurch gekennzeichnet, dass** der Leuchtstoff gemäß Formel I zwischen Primärlichtquelle und dem grün emittierenden Leuchtstoff angebracht ist.

16. Beleuchtungseinheit, insbesondere zur Hintergrundbeleuchtung von Anzeigevorrichtungen, **dadurch gekennzeichnet, dass** sie mindestens eine Lichtquelle nach einem oder mehreren der Ansprüche 11 bis 15 enthält.

17. Anzeigevorrichtung, insbesondere Flüssigkristallanzeigevorrichtung (LC Display), mit einer Hintergrundbeleuchtung, **dadurch gekennzeichnet, dass** sie mindestens eine Beleuchtungseinheit gemäß Anspruch 16 enthält.

18. Verwendung von mindestens einer Verbindung nach Formel I nach einem oder mehreren der Ansprüche 1 bis 4 bzw. einer Mischung nach einem oder mehreren der Ansprüche 5 bis 7 als Konversions-leuchtstoff, insbesondere zur teilweisen oder vollständigen Konversion der blauen oder im nahen UVliegenden Emission einer Lumineszenzdiode.

## Claims

1. Compound of the formula I,
A_{2-0.5y-x} Euₓ Sᵢ₅ N_{8-y} O_{y} (I)
where
A stands for one or more elements selected from Ca, Sr, Ba, and
x stands for a value from the range from 0.005 to 1, and
y stands for a value from the range from 0.1 to 2.5,
**characterised in that** the compound is present together with at least one further silicon- and oxygen-containing compound which is X-ray-amorphous or glass-like.

2. Compound according to Claim 1, **characterised in that** A stands for Sr.

3. Compound according to one or more of Claims 1 or 2, **characterised in that** x stands for a value from the range from 0.01 to 0.8, preferably from the range from 0.02 to 0.7 and particularly preferably from the range from 0.05 to 0.6.

4. Compound according to one or more of Claims 1 to 3, **characterised in that** y stands for a value from the range from 0.2 to 2 and preferably from the range from 0.22 to 1.8.

5. Mixture comprising at least one compound of the formula I,
A_{2-0.5y-x} Euₓ Si₅ N_{8-y} O_{y} (I)
where
A stands for one or more elements selected from Ca, Sr, Ba, and
x stands for a value from the range from 0.005 to 1, and
y stands for a value from the range from 0.1 to 2.5 and
at least one further silicon- and oxygen-containing compound, **characterised in that** the silicon- and oxygen-containing compound is X-ray-amorphous or glass-like.

6. Mixture according to Claim 5, **characterised in that** the compound of the formula I is present in the mixture in a proportion by weight from the range 30 - 95% by weight, preferably from the range 50 - 90% by weight and particularly preferably from the range 60 - 88% by weight.

7. Mixture according to one or more of Claims 5 or 6, **characterised in that** the mixture is obtainable by a process in which, in a step a), suitable starting materials selected from binary nitrides, halides and oxides are mixed, and, in a step b), the mixture is thermally treated under reductive conditions.

8. Process for the preparation of a compound according to one or more of Claims 1 to 4 or of a mixture according to one or more of Claims 5 to 7, **characterised in that**, in a step a), suitable starting materials selected from binary nitrides, halides and oxides are mixed, and, in a step b), the mixture is thermally treated under reductive conditions.

9. Process according to Claim 8, **characterised in that**, in step b), the reaction is carried out at a temperature above 800°C, preferably at a temperature above 1200°C and particularly preferably in the range 1400°C - 1800°C.

10. Process according to one or more of Claims 8 or 9, **characterised in that** step b) is carried out in a stream of nitrogen, preferably in a stream of N₂/H₂ and particularly preferably in a stream of N₂/H₂/NH₃.

11. Light source having at least one primary light source, **characterised in that** the light source comprises at least one phosphor of the formula I according to one or more of Claims 1 to 4 or a mixture according to one or more of Claims 5 to 7.

12. Light source according to Claim 11, **characterised in that** the primary light source is a luminescent indium aluminium gallium nitride, in particular of the formula InᵢGaⱼAlₖN, where 0 0 ≤ i, 0 ≤ j, 0 ≤ k, and I + j + k = 1.

13. Light source according to one or more of Claims 11 or 12, **characterised in that** the light source comprises a green-emitting phosphor.

14. Light source according to one or more of Claims 11 to 13, **characterised in that** the phosphors are arranged on the primary light source in such a way that the phosphor of the formula I is irradiated essentially by light from the primary light source, while the green-emitting phosphor is irradiated essentially by light which has already passed through the red-emitting phosphor or has been scattered thereby.

15. Light source according to Claim 14, **characterised in that** the phosphor of the formula I is installed between the primary light source and the green-emitting phosphor.

16. Lighting unit, in particular for the backlighting of display devices, **characterised in that** it comprises at least one light source according to one or more of Claims 11 to 15.

17. Display device, in particular liquid-crystal display device (LC display), having backlighting, **characterised in that** it comprises at least one lighting unit according to Claim 16.

18. Use of at least one compound of the formula I according to one or more of Claims 1 to 4 or of a mixture according to one or more of Claims 5 to 7 as conversion phosphor, in particular for the partial or complete conversion of the blue or near-UV emission from a luminescent diode.

## Revendications

1. Composé de la formule I :
A_{2-0.5y-x} Euₓ Si₅ N_{8-y} O_{y} (I)
dans laquelle :
A représente un ou plusieurs élément(s) choisi(s) parmi Ca, Sr, Ba, et
x représente une valeur dans la plage de 0,005 à 1, et
y représente une valeur dans la plage de 0,1 à 2,5,
**caractérisé en ce que** le composé est présent en association avec au moins un autre composé contenant du silicium et de l'oxygène, lequel est amorphe vis-à-vis des rayons X ou similaire à du verre.

2. Composé selon la revendication 1, **caractérisé en ce que** A représente Sr.

3. Composé selon une ou plusieurs des revendications 1 ou 2, **caractérisé en ce que** x représente une valeur dans la plage de 0,01 à 0,8, de façon préférable, dans la plage de 0,02 à 0,7 et de façon particulièrement préférable, dans la plage de 0,05 à 0,6.

4. Composé selon une ou plusieurs des revendications 1 à 3, **caractérisé en ce que** y représente une valeur dans la plage de 0,2 à 2 et de façon préférable, dans la plage de 0,22 à 1,8.

5. Mélange comprenant au moins un composé de la formule I :
A_{2-0.5y-x} Euₓ Si₅ N_{8-y} O_{y} (I)
dans laquelle :
A représente un ou plusieurs élément(s) choisi(s) parmi Ca, Sr, Ba, et
x représente une valeur dans la plage de 0,005 à 1, et
y représente une valeur dans la plage de 0,1 à 2,5 et
au moins un autre composé contenant du silicium et de l'oxygène, **caractérisé en ce que** le composé contenant du silicium et de l'oxygène est amorphe vis-à-vis des rayons X ou similaire à du verre.

6. Mélange selon la revendication 5, **caractérisé en ce que** le composé de la formule I est présent dans le mélange selon une proportion en poids dans la plage de 30 - 95% en poids, de façon préférable, dans la plage de 50 - 90% en poids et de façon particulièrement préférable, dans la plage de 60 - 88% en poids.

7. Mélange selon une ou plusieurs des revendications 5 ou 6, **caractérisé en ce que** le mélange peut être obtenu au moyen d'un procédé selon lequel, au niveau d'une étape a), des matériaux de départ appropriés choisis parmi des nitrures, des halogénures et des oxydes binaires sont mélangés et, au niveau d'une étape b), le mélange est traité thermiquement sous des conditions de réduction.

8. Procédé pour la préparation d'un composé selon une ou plusieurs des revendications 1 à 4 ou d'un mélange selon une ou plusieurs des revendications 5 à 7, **caractérisé en ce que**, au niveau d'une étape a), des matériaux de départ appropriés choisis parmi des nitrures, des halogénures et des oxydes binaires sont mélangés et, au niveau d'une étape b), le mélange est traité thermiquement sous des conditions de réduction.

9. Procédé selon la revendication 8, **caractérisé en ce que**, au niveau de l'étape b), la réaction est mise en oeuvre à une température supérieure à 800°C, de façon préférable, à une température supérieure à 1200°C et de façon particulièrement préférable, dans la plage de 1400°C - 1800°C.

10. Procédé selon une ou plusieurs des revendications 8 ou 9, **caractérisé en ce que** l'étape b) est mise en oeuvre dans un courant d'azote, de façon préférable, dans un courant de N₂/H₂ et de façon particulièrement préférable, dans un courant de N₂/H₂/NH₃.

11. Source de lumière comportant au moins une source de lumière primaire, **caractérisée en ce que** la source de lumière comprend au moins un phosphore de la formule I selon une ou plusieurs des revendications 1 à 4 ou un mélange selon une ou plusieurs des revendications 5 à 7.

12. Source de lumière selon la revendication 11, **caractérisée en ce que** la source de lumière primaire est nitrure d'indium-aluminium-gallium luminescent, en particulier de la formule InᵢGaⱼAlₖN, où 0 ≤ i, 0 ≤ j, 0 ≤ k, et I + j + k = 1.

13. Source de lumière selon une ou plusieurs des revendications 11 ou 12, **caractérisée en ce que** la source de lumière comprend un phosphore émetteur de vert.

14. Source de lumière selon une ou plusieurs des revendications 11 à 13, **caractérisée en ce que** les phosphores sont agencés sur la source de lumière primaire de telle sorte que le phosphore de la formule I soit irradié essentiellement par la lumière en provenance de la source de lumière primaire, tandis que le phosphore émetteur de vert est irradié essentiellement par la lumière qui a déjà traversé le phosphore émetteur de rouge ou qui a été diffusée par celui-ci.

15. Source de lumière selon la revendication 14, **caractérisée en ce que** le phosphore de la formule I est installé entre la source de lumière primaire et le phosphore émetteur de vert.

16. Unité d'éclairage, en particulier pour l'éclairage arrière de dispositifs d'affichage, **caractérisée en ce qu'**elle comprend au moins une source de lumière selon une ou plusieurs des revendications 11 à 15.

17. Dispositif d'affichage, en particulier dispositif d'affichage à cristaux liquides (affichage LC), comportant un éclairage arrière, **caractérisé en ce qu'**il comprend au moins une unité d'éclairage selon la revendication 16.

18. Utilisation d'au moins un composé de la formule I selon une ou plusieurs des revendications 1 à 4 ou d'un mélange selon une ou plusieurs des revendications 5 à 7 en tant que phosphore de conversion, en particulier pour la conversion partielle ou complète de l'émission de bleu ou des UV proches en provenance d'une diode luminescente.
